# EUROPEAN PATENT SPECIFICATION

(11) **EP 0 363 548 B1**
(45) Date of publication and mention of the grant of the patent: **23.03.1994**
(21) Application number: 88810694.5
(22) Date of filing: 10.10.1988
(51) Int. Cl.: H01L 21/00, B26F 3/00

(54) **Method of breaking a plate-like workpiece such as a semi-conductor wafer, and device for breaking said workpiece sandwiched between two foils**
Verfahren zum Brechen eines plattenförmigen Werkstücks, insbesondere eines Halbleiterplättchens, und Vorrichtung zum Brechen des genannten zwischen zwei Folien sandwichartig angeordneten Werkstücks
Procédé pour briser une pièce de travail sous forme de plaque, en particulier d'une plaquette semi-conductrice, et dispositif pour briser ladite pièce de travail disposée entre deux feuilles sous forme de sandwich

(43) Date of publication of application: 18.04.1990
(73) Proprietor: International Business Machines Corporation, Armonk, N.Y. 10504 (US)
(72) Inventor: Richard, Heinz, CH-8802 Kilchberg (CH)
(74) Representative: Barth, Carl Otto

(56) References cited:
- DE-A- 1 427 772
- US-A- 3 396 452
- US-A- 3 667 661
- US-A- 3 790 051
- I.B.M. TECHNICAL DISCLOSURE BULLETIN vol. 23, no. 10, March 1981, New York page 4749 - 4750; R.M. POTEMSKI et al.: "PROCESS FOR BATCH CLEAVING GaAs AND SIMILAR MATERIALS"

## Description

The present invention relates to a method of breaking a plate-like workpiece such as a semiconductor wafer and to a device for breaking a plate-like workpiece sandwiched between two flexible foils.

A method of this kind has been disclosed in IBM Technical Disclosure Bulletin Vol. 23 No. 10 (March 1981) pp. 4749-4750 for cleaving GaAs and similar materials. It involves scribing the wafer surface and then controllably bending the wafer so that it fractures along the scribed lines. Among the operative conditions disclosed as necessary, the following are of relevance in the present invention:
- To cleave a bar of given length L the wafer should be thinner than L/2.
- The scribed wafer should be bent in such manner that the plane of the bending radius is normal to the scribed lines, which should be on the convex side of the wafer.
- The wafer must be mounted on a substrate which is sufficiently rigid to support the wafer but is also deformable to the necessary bending radius and then located on the concave side of the wafer when bent.
- The convex side of the wafer must be constrained in order to prevent stress from being applied on the side of the wafer adjoining the substrate, which stress could separate the wafer from the substrate. A flexible material can be used to cover the wafer and the substrate.
- The sandwich of substrate, wafer and flexible upper foil must be joined by flexible adhesives which are readily removable and which will not in any way damage the cleaved pieces.

A method of bending a wafer so that it fractures along the scribed lines is also described in US-A-3667661.

Non-rigid adhesive sheets are known in the art of fixing semiconductor wafers. They are designed for use in holding semiconductor wafers firmly in place e.g. while breaking processes are performed thereon and made as a sandwich comprised of a non-rigid PVC-foil and a polyester foil joined together by means of an acrylic adhesive. They are available for instance from Nitto Electric Industrial Co. Ltd. (Japan). The adhesion of such foils to each other in the sandwich is indicated to be about 100 to 350 N/m, depending of the type of sheet and the duration of its storage.

A device suitable for breaking a plate-like workpiece sandwiched between two flexible foils of a sheet of the above indicated kind is known in the art, for instance as disclosed in US-A-4653680, and available for instance from Dynatex Corporation, 727 Shasta Street, Redwood City, CA 94063, U.S.A., as shown in their leaflet "DX II Wafer Breaker". This known device is comprised of a movable cross-table having the wafer affixed thereon, a wedge and an anvil therefor. The cross-table has an aperture adapted to be overlaid by the properly oriented wafer. The wedge is made to press the wafer against the anvil through the aperture, the anvil being made of hard rubber so as to be slightly resilient.

It is known in the art to use this known device in such manner that the wafer is covered with a foil which extends beyond the margins of the wafer prior to cleaving and must be transparent, lest the wafer could not be viewed under the microscope for being positioned.

Using this known device, the process of breaking a wafer comprises the steps of: scribing one of the workpiece surfaces with at least one scribing line to define a plane where the workpiece is to be broken; placing the workpiece, with its scribed surface facing upwards, between an upper and a lower foil, both foils being flexible and extending beyond the margins of the workpiece, an adhesive serving to join the workpiece to the lower foil; applying an upward force to the lower side of the sandwich structure to bend the workpiece in such manner that any resulting radius of curvature is orthogonal to the lines scribed on the convex side of the workpiece, so that the workpiece breaks into individual bars as determined by the scribed lines; and removing the upper foil whereafter the lower foil can be stretched so that the individual bars become separated and can be taken from the lower foil for further processing.

Such known device and method of breaking a wafer are not specifically designed and adapted for the manufacture of semiconductor lasers whose mirror facets are obtained as cleavage planes of the semiconductor wafer. Indeed, these mirror facets are very fragile and very often become damaged by crushing which occurs between adjacent laser elements before the latter become separated by stretching the lower foil. The known device also is extremely costly in that the cross-table must be moved while the wafer is observed under a microscope to precisely position the wedge and anvil at each scribed line in succession, and then the wedge must be precisely operated by means of a controlled wedge drive means.

Accordingly, an object of the present invention is to provide a method of breaking a plate-like workpiece such as a semiconductor wafer, which method prevents facets of workpiece elements that are created when the workpiece is being broken from abutting and damaging each other.

Another object of the present invention is to provide a device for breaking a plate-like workpiece sandwiched between two flexible foils, which device is cheap to manufacture as well as simple and easy to operate, and does not require any controlled drive means nor any microscope permanently mounted at the device.

These objects, and others which will become apparent from the description which follows, are attained according to the invention by performing a method of breaking a plate-like workpiece such as a semiconductor wafer, the method comprising the steps of scribing one of the workpiece surfaces with at least one scribing line to define a plane where the workpiece is to be broken; placing the workpiece, with its scribed surface facing upwards, between an upper and a lower foil, both foils being flexible and stretchable and extending beyond the margins of the workpiece, an adhesive serving to join the workpiece to the lower foil; stretching the two foils with the workpiece sandwiched in-between, the workpiece preventing such stretching at least partly within that part of the lower foil to which it adheres; applying an upward force to the lower side of the sandwich structure to bend the workpiece in such manner that any resulting radius of curvature is orthogonal to the scribed lines on the convex side of the workpiece, so that the workpiece breaks into individual bars as determined by the scribed lines thus enabling the part of the lower foil to which the workpiece was initially joined and to which the bars still adhere to further stretch, whereby the individual bars become separated sufficient to avoid mutual damage of the neighboring broken off surfaces; and whilst maintaining the lower foil in the stretched state removing the upper foil whereafter the individual bars can be taken from the lower foil for further processing.

Preferably, the tensile strength of the lower foil is lower that the tensile strength of the upper foil. Also, it is preferred to stretch the sandwich in excess of the limit of elastic deformation of the lower foil and of the upper foil. The workpiece may be made of gallium arsenide, indium phosphide or silicon, or consist of an amorphous material and made of glass. In a particular embodiment of the invention, a piece of intermediate foil is interposed between the upper surface of the workpiece and the upper foil, with the piece of intermediate foil being larger than the workpiece so as to extend all around beyond the workpiece covered therewith. This intermediate foil may be made of polyester or polyimide.

Also, according to the invention, a device for breaking a plate-like workpiece sandwiched between two flexible foils comprises: a base element having an essentially plane upper surface, its longitudinal extension being larger than that in the transverse direction; first gripping means fixedly positioned at one end of the base element, provided and arranged for releasably holding one end of the sandwich of the wafer and foils; second gripping means movably arranged with respect to the base element and positioned at the other end thereof for movement in the longitudinal direction, provided and arranged for releasably holding the other end of said sandwich; displacing means arranged for adjustably displacing the second gripping means in the longitudinal direction; and a cylindrical rod adapted to be placed on the upper surface of the base element with its cylinder axis parallel to the transverse direction and to be movable in the longitudinal direction.

Preferably, the base element is provided at its upper surface with a groove parallel to the transverse direction and adapted to receive the rod so as to completely accommodate it below the plane of the upper surface of the base element, the rod is provided with a pair of rollers symmetrically mounted thereon by means of respective bearings and spaced from each other by more than the width of the sandwich transverse to its lengthwise direction extending between its ends, and the base element is provided at its upper surface with a pair of recessed cavities each connected to the groove and each adapted to accommodate at least a portion of a respective roller when the rod is accommodated in the groove. Also, the base element may be provided at its upper surface with a pair of recessed tracks each connected to a respective recessed cavity, extending in longitudinal direction and adapted to accommodate a portion of a respective roller so as to position the rod parallel to the transverse direction.

Preferably, the displacing means are comprised of two guide bars affixed to the base element parallel to the longitudinal direction, a chariot gliding on the guide bars and having a threaded bore parallel to the longitudinal direction, and a spindle adapted to be screwed into the bore and to have one end abutting on the base element, the other end of the spindle being operable to rotate the spindle, the second gripping means being affixed to the chariot so as to be arranged at the base element by means of the displacing means. Also the gripping means may be clamps adapted to be pressed in a pressing direction perpendicular to the upper surface of the base element, respectively against the base element and the chariot, by means of a respective pair of spindles screwed in pressing direction into respective bores of the base element and the chariot, the spindles having respective knobs adapted to abut in pressing direction against an upper face of the respective clamp parallel to and facing away from the upper surface of the base element, the spindles being spaced from each other by more than the width of the sandwich. Moreover, spring means may be provided to press the clamps away from the base element and the chariot, respectively, into abutment on the knobs of the respective spindles.

The method of the invention, preferably when implemented with the device according to the invention, allows to stretch the lower foil after the workpiece has been adhered to it. As the lower foil has been at least partly prevented from stretching at such locations where it adheres to the workpiece, when the workpiece is broken the foil becomes capable of stretching at least in the vicinity of the newly created facets obtained as breakage planes of the workpiece. This allows the facets to become spaced from each other, which efficiently prevents damage by crushing to occur between adjacent elements of the workpiece when broken.

Also, the device according to the invention is cheap to manufacture as well as simple and easy to operate. It is small and light and thus easy to be installed for operation or put away for storage in a cabinet. Thus, it is suitable for mass production and for use by non-skilled operators.

The invention will be described in closer detail in the following with reference to the accompanying drawings wherein:
- Fig. 1: is a schematic plan view of an exemplary embodiment of the device according to the invention, having a workpiece and foils sandwich mounted thereon in view of breaking the workpiece and having a breaking tool positioned at rest before the process of breaking the workpiece has been started;
- Fig. 2: is a schematic side view of the device, sandwich and breaking tool of Fig. 1;
- Fig. 3: is a schematic plan view of the breaking tool;
- Figs. 4 and 5: show the device according to the invention as in Figs. 1 and 2 but with the workpiece and foils sandwich and the breaking tool in a position where breaking is about to proceed; and
- Fig. 6: is a schematic longitudinal section of a central portion of a particular embodiment of the workpiece and foils sandwich.

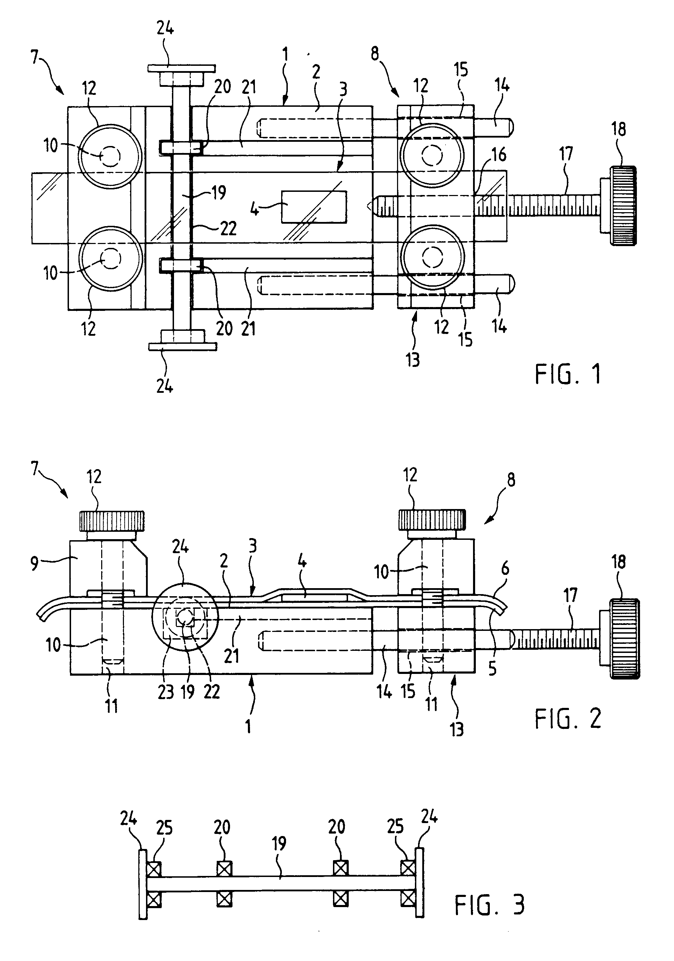

The embodiment of the device according to the invention which is illustrated in Figs. 1 and 2 has a base element 1 adapted to receive a workpiece and foils sandwich 3. For this purpose, base element 1 has an essentially plane upper surface 2, and is constructed rectangular with greater extension in a longitudinal extension of base element 1 than in a transverse extension thereof.

Sandwich 3 is comprised of a wafer-like workpiece 4 about to be broken and which is scribed on one of its surfaces with at least one scribing line to define where workpiece 4 is to be broken. Such wafer-like workpiece 4 is de-limited by plane upper and lower surfaces parallel to each other and spaced by less than half the smallest dimension of its upper or lower surface. In an exemplary embodiment, workpiece 4 is a semiconductor wafer of gallium arsenide. More generally, however, workpiece 4 can be any wafer-like piece of monocristalline material which is to be cleaved along a desired cleavage plane, such as the aforesaid gallium arsenide or indium phosphide or silicon, or any a plate-like piece of amorphous material which is to be broken along a desired breakage plane, such as glass.

Workpiece 4 is sandwiched with its scribed surface facing upwards between a lower foil 5 and an upper foil 6. Both foils 5 and 6 extend beyond the margins of workpiece 4 so as to completely enclose the latter. In one exemplary embodiment, workpiece 4 is a gallium arsenide chip having dimensions of about 8 x 8 x 0,1 mm and sandwich 3 has dimensions of about 50 x 10 x 0,2 mm to 100 x 25 x 0,2 mm. In another exemplary embodiment, workpiece 4 is a glass plate having dimensions of about 18 x 18 x 0,16 mm and sandwich 3 has approximately the same dimensions as above.

An adhesive which may be of the acrylic type, as known in the art, is provided on the upper face of lower foil 5 and serves to join the latter to either workpiece 4 or upper foil 6. The adhesive force may be selected as small as possible but sufficient to prevent workpiece 4 and the individual bars into which workpiece 4 is eventually broken from falling off lower foil 5 on manipulation thereof. An adhesive force of about 100 N/m may be considered proper.

Both foils 5 and 6 are flexible and can be stretched by more than 10 % without being damaged, and the tensile strength of lower foil 5 is lower that the tensile strength of upper foil 6. To this effect, the lower foil 5 may be for instance about 0,1 mm thick and made of polyvinyl chloride and the upper foil 6 may be for instance about 0,01 mm thick and made of polyester. To stretch the foils of sandwich 3, base element 1 is provided with first and second gripping means 7 and 8 each for releasably holding a portion of sandwich 3 near to a respective end thereof on the whole width thereof in the plane of the upper surface parallel to the transverse direction of base element 1, and with displacing means arranged for adjustably displacing the second gripping means in the longitudinal direction of base element 1.

First gripping means 7 is fixedly positioned in respect of base element 1 and constructed as a clamp 9 adapted to be pressed against base element 1 in a direction perpendicular its upper surface 2 by means of a pair of spindles 10 screwed into respective bores 11 of base element 1. Spindles 10 have respective knobs 12 adapted to abut in pressing direction against an upper face of clamp 9. Spindles 10 are spaced from each other by more than the width of sandwich 3 to provide passage of the latter between them. Spring means not shown are provided to press clamp 9 away from upper surface 2 of base element 1 into abutment onto knobs 12. Thus, screwing or unscrewing knobs 12 allows to respectively hold or release the clamped portion of sandwich 3.

Second gripping means 8 is constructed similar to first gripping means 7 but positioned spaced therefrom at a chariot 13, an upper surface of which is in the same plane as upper surface 2 of base element 1.

Chariot 13 is movably arranged at base element 1 for movement in its longitudinal direction and is thus part of the aforesaid displacing means. The displacing means further comprise a pair of guide bars 14 affixed to base element 1 parallel to its longitudinal direction and which can be inserted into respective bores 15 of chariot 13 to serve as support and guide means on which chariot 13 can be made to glide. Also, chariot 13 has a threaded bore 16 parallel to the longitudinal direction of base element 1 and a spindle 17 adapted to be screwed into bore 16. One end of spindle 17 can be made to abut base element 1 and at its other end spindle 17 is operable to be rotated by means of a knob 18. Screwing or unscrewing spindle 17 while it is abutting base element 1 allows to move chariot 13 to respectively increase or decrease the spacing between chariot 13 and base element 1. Thus, second gripping means 8 is movably arranged at base element 1 by means of the displacing means for being adjustably displaced in the longitudinal direction of base element 1.

It will readily appear that when sandwich 3 is gripped between gripping means 7 and 8 by having its ends clamped therein, operating knob 18 to increase the spacing between chariot 13 and base element 1 will first make sandwich 3 to extend to its full length. Any further increase will stretch sandwich 3 at first in the elastic and then in the plastic deformation range of its foils 5 and 6. Considering that the tensile strength of lower foil 5 is selected to be lower than the tensile strength of upper foil 6, to stretch sandwich 3 in excess of the limit of elastic deformation both of lower foil 5 and of upper foil 6 will ensure that upper foil 6 constrains the upper side of workpiece 4 more than lower foil 5 constrains the lower side of workpiece 4. Thus, the scribed surface of workpiece 4 is constrained as requested in the art of breaking and can be made the convex side of workpiece 4 when the latter is bent to perform the actual breaking process step.

To proceed to break workpiece 4, a bending tool must be provided whose purpose is to apply an upward force to the lower side of sandwich 3 to bend workpiece 4 in such manner that the bending radius is orthogonal to the scribed lines on the convex side of workpiece 4. Upon bending, the workpiece breaks into individual bars as determined by the scribed lines and also by preferential cleavage planes if the workpiece material is crystalline. However, the bending tool generally is not needle-shaped and contacts the lower side of workpiece 4 along a breakage line which, together with the scribed line, determines the breakage plane. Thus, workpiece 4 and the bending tool should be properly oriented in respect of each other to ensure that breaking occurs along the desired plane.

In the device according to the invention, the bending tool is a cylindrical rod 19 adapted to be placed on the upper surface 2 of base element 1 with its cylinder axis parallel to the transverse direction of base element 1 and to be movable in the longitudinal direction of base element 1. The diameter of this rod is about 5 % of the length of the sandwich between gripping means 7 and 8.

To ensure and maintain its proper orientation, rod 19 is provided with a pair of rollers 20 symmetrically mounted thereon by means of respective bearings and spaced from each other by more than the width of sandwich 3 transverse to the longitudinal direction of base element 1. On the other hand, upper surface 2 of base element 1 is provided with a pair of recessed tracks 21 extending in longitudinal direction of base element 1 and adapted to accommodate a portion of a respective roller 20 so that rollers 20 and tracks 21 cooperate to position and maintain rod 19 parallel to the transverse direction of base element 1.

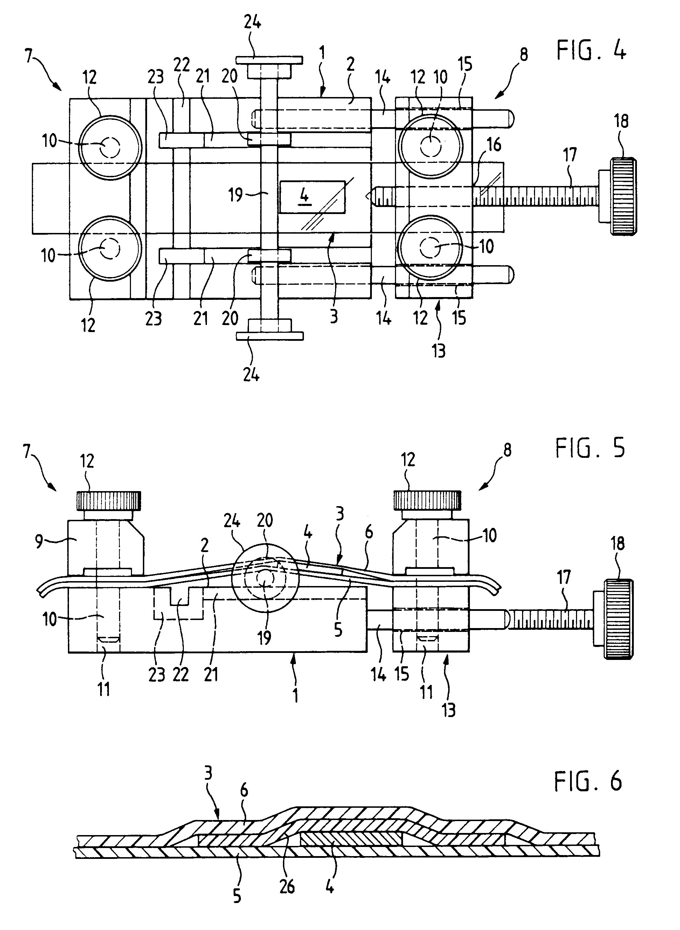

Also, upper surface 2 of base element 1 is provided with a groove 22 (shown in Figs. 4 and 5) parallel to the transverse direction of base element 1. Groove 22 is adapted to receive rod 19 (as shown in Figs. 1 and 2) so as to completely accommodate it in a rest position thereof below the plane of upper surface 2 of base element 1. To allow rod 19 to be completely accommodated in groove 22 so as not to protrude above upper surface 2 of base element 1, upper surface 2 of base element 1 is provided with a pair of recessed cavities 23 each connected to groove 22 and to a respective track 21 and each adapted to accommodate at least a portion of a respective roller 20 in the rest position of rod 19.

To provide unhindered and easy operation of rod 19 as a breaking tool, rod 19 is made longer than the width of base element 1 parallel to its transverse direction and is provided with a pair of operating knobs 24 symmetrically mounted at the ends of rod 19 by means of respective bearings 25. This provision also ensures that rod 19 is able to rotate freely as required by its eventual friction on upper surface 2 of base element 1 and on the lower side of lower foil 5.

For sandwich 3 to be stretched properly as required for breaking workpiece 4, it must be made to lie flat on upper surface 2 of base element 1, so that rod 19 is required to be in its rest position while sandwich 3 is stretched as indicated above. It will readily appear that in this rest position rod 19 is located below sandwich 3, although still between base element 1 and sandwich 3. An alternative to placing rod 19 to rest in groove 22 would be to position rod 19 on guide bars 14 between base element 1 and chariot 13, provided there also is sufficient space in-between to accommodate as much of rollers 20 as is needed to allow rod 19 to be positioned below sandwich 3.

Also, workpiece 4 is required to lie on base element 1 with the desired breakage planes oriented parallel to the transverse direction of base element 1. This is attained by orienting sandwich 3 in respect of rod 19 prior to clamping it in gripping means 7 and 8, which can be done manually by moving sandwich 3 in respect of upper surface 2 of base element 1 while observing workpiece 4 under a microscope through upper foil 6, which usually is transparent or at least translucent.

This conditions being fulfilled, to proceed to break workpiece 4 an operator manually lifts rod 19 with the help of knobs 24 from its rest position and out of groove 22 (or out of the space between base element 1 and chariot 13) and then moves rod 19 in the proper longitudinal direction of base element 1 (away from the groove or from the above mentioned space) until it can rest on upper surface 2 thereof. In doing this, the operator has lifted lower foil 5 from upper surface 2 of base element 1 in the vicinity of groove 22 so as to insert rod 19 between lower foil 5 and upper surface 2 of base element 1.

The operator then moves rod 19 further in the same longitudinal direction of base element 1 with the help of knobs 24 until rod 19 abuts workpiece 4 through lower foil 5 in sandwich 3 due the flexibility of lower foil 5. This stage of the breaking process is illustrated in Figs. 4 and 5 in the case of rod 19 having started from groove 22. In a variant, depending on geometrical proportions of the device and the length of workpiece 4, the tension of foils 5 and 6 of sandwich 3 is sufficient to move rod 19 into the described abutting position. In a further variant, the operator moves chariot 13 by means of knob 18 to increase the tension of foils 5 and 6 to bring about this movement of rod 19 to the described abutting position.

The operator then moves rod 19 still further in the same longitudinal direction of base element 1 with the help of knobs 24 until rod 19 is positioned below workpiece 4 in sandwich 3, which movement bends workpiece 4 by forcing its lower side to become concave while its upper side forced convex is still constrained by upper foil 6 as required to prevent stress from being applied on the lower side of workpiece 4 adjoining lower foil 5, which stress could separate workpiece 4 from lower foil 5.

To now describe the phenomenon observed in sandwich 3 when and where breakage of workpiece 4 occurs, reference first must be made to the prior situation. Prior to stretching sandwich 3, workpiece 4 had been sandwiched between foils 5 and 6 and made to adhere to lower foil 5. Thus, when sandwich 3 has been stretched, workpiece 4 has prevented such stretching at least partly within that part of lower foil 5 to which it adheres. Now, at the moment breakage occurs at some location of workpiece 4, lower foil 5 is no more prevented from stretching in the vicinity of this location. This enables that part of lower foil 5 to which workpiece 4 was initially joined and at which workpiece breakage has occurred to further stretch, whereby the individual workpiece elements that are created when workpiece 4 is being broken immediately become separated upon being broken off from the bulk workpiece. This separation is sufficient to avoid mutual damage of neighboring broken off facets due to the facets abutting and crushing each other.

After workpiece 4 has been broken at the desired locations, rod 19 is moved still further in the same longitudinal direction of base element 1 sufficient to prevent any future interference between rod 19 and the workpiece elements. In order to maintain the tension, it must be assured that rod 19 does not drop from upper surface 2 into the space between base element 1 and chariot 13. A stop (not shown) mounted on base element 1 can serve this purpose. The operator then cuts upper foil 6 in the vicinity of each of clamps 9, using for instance a cutter blade or small scissors. After having removed the cut off portion of upper foil 6 for instance by means of tweezers or of a suction device, the operator actuates knob 18 to further increase the spacing between chariot 13 and base element 1 so as to further stretch lower foil 5 considerably, e.g. by 50% of its initial unstretched length between clamps 9. As a result, lower foil 5 is stretched in the plastic deformation range and will not revert to its length at breaking time upon release of the stretching action. At the same time, the individual workpiece elements, for instance semiconductor laser bars, that are created when workpiece 4 is being broken become still more separated from each other and will not revert to positions immediately adjacent to each other upon release of the stretching action. This ensures an easy removal thereof from lower foil 5 for further processing, which removal is done for instance by means of tweezers or of a suction device and is facilitated in that the considerably increased separation between the facets of the individual workpiece elements practically eliminates the risk of these facets being damaged while the elements are taken from lower foil 5.

Preferably, a piece of intermediate foil 26 is interposed between the upper surface of workpiece 4 and upper foil 6 when sandwich 3 is made. This piece of intermediate foil 26 is larger than workpiece 4 and placed thereon so as to extend all around beyond workpiece 4. Sandwich 3 then consists of three layers of foil as shown in Fig. 6, namely (from bottom to top) of lower foil 5, intermediate foil 26 and upper foil 6, while workpiece 4 is inserted between lower foil 5 and intermediate foil 26 in a portion of sandwich 3. The purpose of intermediate foil 26 is to reduce friction between the upper surface of workpiece 4 and upper foil 6 so as to improve the gliding ability of the upper surface of workpiece 4 in respect of that foil which is constraining workpiece 4 without having to reduce the strain applied to workpiece 4. This results in reduced stress and ensuing damage at edges and corners of workpiece 4. To obtain this effect, the intermediate foil may be made of polyester or polyimide for instance about 0,02 mm thick.

As will readily appear, that feature of rod 19 which is functional in performing the breaking of workpiece 4 is only the upper part of its cylindrical mantle surface. Thus, it is equivalent to use the rod-shaped breaking tool described in the preceding or to use any breaking tool having at its upper portion a mantle surface whose mantle lines are parallel to the desired breaking planes. In this sense, even the straight edge of a blade is equivalent to rod 19. Breaking is then performed by displacing the breaking tool so as to bring it into tangential contact with sandwich 3 and then bending sandwich 3 along the mantle surface of the breaking tool.

To summarize the described method of breaking a plate-like workpiece such as a semiconductor wafer: the operator scribes an upper surface of the workpiece to define one or more planes where the workpiece is to be broken; he places the workpiece in sandwich between an upper and a lower foil with its scribed surface facing upwards, preferably after having inserted an intermediate foil between the workpiece and the upper foil; he stretches the sandwich; he applies an upward force to the lower side of the sandwich structure to bend the workpiece; and he removes the upper foil (and the intermediate foil if need be), whereafter he takes the individual bars from the lower foil for further processing.

## Claims

1. A method of breaking a plate-like workpiece (4) such as a semiconductor water into individual bars, the method comprising the steps of:
- scribing one of the workpiece surfaces with at least one scribing line to define a plane where the workpiece is to be broken;
- placing the workpiece (4), with its scribed surface facing upwards, between an upper (6) and a lower (5) foil, both foils being flexible and stretchable and extending beyond the margins of the workpiece, an adhesive serving to join the workpiece (4) to the lower foil (5);
- stretching the two foils with the workpiece sandwiched in-between, the workpiece preventing such stretching at least partly within that part of the lower foil to which it adheres;
- applying an upward force to the lower side of the sandwich structure (3) to bend the workpiece (4) in such manner that any resulting radius of curvature is orthogonal to the lines scribed on the convex side of the workpiece, so that the workpiece breaks into individual bars as determined by the scribed lines thus enabling the part of the lower foil (5) to which the workpiece (4) was initially joined and to which the bars still adhere to further stretch, whereby the individual bars become separated sufficient to avoid mutual damage of the neighboring broken off surfaces, and
- whilst maintaining lower foil (5) in the stretched state removing the upper foil (6), whereafter the individual bars can be taken from the lower foil (5) for further processing.

2. The method of claim 1, wherein the tensile strength of the lower foil (5) is lower that the tensile strength of the upper foil (6).

3. The method of claim 1, wherein the sandwich (3) is stretched in excess of the limit of elastic deformation of the lower foil (5) and of the upper foil (6).

4. The method of claim 1, wherein the workpiece (4) is made of gallium arsenide, indium phosphide or silicon.

5. The method of claim 1, wherein the workpiece (4) consists of an amorphous material and is made of glass.

6. The method of claim 1, wherein a piece of intermediate foil (26) is interposed between the upper surface of the workpiece (4) and the upper foil (6), with the piece of intermediate foil being larger than the workpiece so as to extend all around beyond the workpiece covered therewith.

7. The method of claim 6, wherein the intermediate foil (26) is made of polyester or polyimide.

8. A device for breaking a plate-like workpiece (4) sandwiched between two flexible foils (5,6), the device comprising:
- a base element (1) having an essentially plane upper surface (2), its longitudinal extension being larger than that in the transverse direction;
- first gripping means (7) fixedly positioned at one end of the base element, provided and arranged for releasably holding one end of the sandwich (3) of the wafer and foils;
- second gripping means (8) movably arranged with respect to the base element and positioned at the other end thereof for movement in the longitudinal direction, provided and arranged for releasably holding the other end of said sandwich (3);
- displacing means (13-18) arranged for adjustably displacing the second gripping means (8) in the longitudinal direction; and
- a cylindrical rod (19) adapted to be placed on the upper surface (2) of the base element (1) with its cylinder axis parallel to the transverse direction and to be movable in the longitudinal direction.

9. The device of claim 8, wherein the base element (1) is provided at its upper surface (2) with a groove (22) parallel to the transverse direction and adapted to receive the rod (19) so as to completely accommodate it below the plane of the upper surface (2) of the base element (1), the rod (19) is provided with a pair of rollers (20) symmetrically mounted thereon by means of respective bearings and spaced from each other by more than the width of the sandwich (3) transverse to its lengthwise direction extending between its ends, and the base element (1) is provided at its upper surface (2) with a pair of recessed cavities (23) each connected to the groove (22) and each adapted to accommodate at least a portion of a respective roller (20) when the rod (19) is accommodated in the groove (22).

10. The device of claim 9, wherein the base element (1) is provided at its upper surface (2) with a pair of recessed tracks (21) each connected to a respective recessed cavity (23), extending in longitudinal direction and adapted to accommodate a portion of a respective roller (20) so as to position the rod (19) parallel to the transverse direction.

11. The device of claim 8, wherein the displacing means (13-18) are comprised of two guide bars (14) affixed to the base element (1) parallel to the longitudinal direction, a chariot (13) gliding on the guide bars (14) and having a threaded bore (16) parallel to the longitudinal direction, and a spindle (17) adapted to be screwed into the bore (16) and to have one end abutting on the base element (1), the other end (18) of the spindle (17) being operable to rotate the spindle, the second gripping means (8) being affixed to the chariot (13) so as to be arranged at the base element (1) by means of the displacing means (13-18).

12. The device of claim 11, wherein the gripping means (7,8) are clamps (9) adapted to be pressed in a pressing direction perpendicular to the upper surface (2) of the base element (1), respectively against the base element (1) and the chariot (13), by means of a respective pair of spindles (10) screwed in pressing direction into respective bores (11) of the base element (1) and the chariot (13), the spindles (10) having respective knobs (12) adapted to abut in pressing direction against an upper face of the respective clamp (9) parallel to and facing away from the upper surface (2) of the base element (1), the spindles (10) being spaced from each other by more than the width of the sandwich (3).

13. The device of claim 12, wherein spring means are provided to press the clamps (9) away from the base element (1) and the chariot (13), respectively, into abutment on the knobs (12) of the respective spindles (10).

## Patentansprüche

1. Verfahren zum Brechen eines plattenförmigen Werkstücks (4), insbesondere eines Halbleiterplättchens in einzelne Leisten, wobei das Verfahren folgende Schritte umfaßt:
- Anreißen einer der Flächen des Werkstücks mit mindestens einer Anrißlinie zur Festlegung einer Ebene, entlang der das Werkstück gebrochen werden soll;
- Setzen des Werkstücks (4) zwischen einer oberen (6) und unteren (5) Folie mit der angerissenen Fläche nach oben, wobei beide Folien flexibel und dehnbar sein und sich über die Ränder des Werkstücks hinaus erstrecken müssen, und wobei ein Klebstoff dazu verwendet wird, um das Werkstück (4) an der unteren Folie (5) zu befestigen;
- Dehnung der beiden Folien, wobei sich das Werkstück in einer sandwichartigen Anordnung zwischen den Folien befindet und wobei das Werkstück die Dehnung an dem Abschnitt der unteren Folie, an der es klebt, zumindest teilweise verhindert;
- Anlegen einer nach oben gerichteten Kraft an der unteren Seite der sandwichartigen Anordnung (3), um das Werkstück (4) so zu biegen, daß ein resultierender Kurvenradius rechtwinklig zu den angerissenen Linien auf der konvexen Seite des Werkstücks ist, so daß das Werkstück in einzelne Leisten zerbricht, wie dies durch die angerissenen Linien vorgegeben ist, wodurch sich der Teil der unteren Folie (5), an dem das Werkstück (4) ursprünglich befestigt war und an dem sich die Leisten noch immer befinden, weiter dehnen läßt, wodurch die einzelnen Leisten ausreichend weit voneinander getrennt werden, um eine gegenseitige Beschädigung benachbarter gebrochener Flächen zu verhindern, und
- während die untere Folie (5) in gedehntem Zustand gehalten wird, Entfernen der oberen Folie (6), wonach die einzelnen Leisten von der unteren Folie (5) zur weiteren Verarbeitung abgenommen werden können.

2. Verfahren gemäß Anspruch 1, wobei die Zugfestigkeit der unteren Folie (5) geringer ist als die Zugfestigkeit der oberen Folie (6).

3. Verfahren gemäß Anspruch 1, wonach die sandwichartige Anordnung (3) über die Grenze der elastischen Verformung der unteren Folie (5) und der oberen Folie (6) hinaus gedehnt wird.

4. Verfahren gemäß Anspruch 1, wonach das Werkstück (4) aus Galliumarsenid, Indiumphosphid oder Silizium besteht.

5. Verfahren gemäß Anspruch 1, wonach das Werkstück (4) aus einem amorphen Material beschaffen ist und aus Glas besteht.

6. Verfahren gemäß Anspruch 1, wonach zwischen der oberen Fläche des Werkstücks (4) und der oberen Folie (6) ein Stück Zwischenfolie (26) eingesetzt wird, wobei das Stück Zwischenfolie größer ist als das Werkstück, so daß es das Werkstück vollständig bedeckt.

7. Verfahren gemäß Anspruch 6, wonach die Zwischenfolie (26) aus Polyester oder Polyimid besteht.

8. Einrichtung zum Brechen eines plattenförmigen Werkstücks (4), das sich in einer sandwichartigen Anordnung zwischen zwei flexiblen Folien (5, 6) befindet, wobei die Einrichtung folgendes umfaßt:
- ein Basiselement (1) mit einer im wesentlichen ebenen oberen Fläche (2), wobei dessen Längsausdehnung größer ist als die Ausdehnung in Querrichtung;
- ein erstes Greifmittel (7), das an einem Ende des Basiselements fest angebracht und so ausgelegt ist, daß es ein Ende der sandwichartigen Anordnung (3) des Plättchens und der Folien aufnehmen kann;
- ein zweites Greifmittel (8), das bezüglich des Basiselements beweglich so angeordnet und am anderen Ende so positioniert ist, daß es sich in Längsrichtung bewegt und so ausgelegt ist, daß es das andere Ende der sandwichartigen Anordnung (3) festhält;
- Bewegungsmittel (13-18), das so angeordnet ist, daß es das zweite Greifmittel (8) in Längsrichtung einstellbar bewegen kann; und
- eine zylindrische Stange (19), die so auf der oberen Fläche (2) des Basiselements 1 angebracht werden kann, daß ihre Zylinderachse parallel zur Querrichtung liegt und in Längsrichtung beweglich ist.

9. Einrichtung gemäß Anspruch 8, wonach das Basiselement (1) an seiner oberen Fläche (2) eine Rille (22) aufweist, die parallel zur Querrichtung verläuft, und welches so ausgelegt ist, daß es die Stange (19) so aufnehmen kann, daß diese vollständig unterhalb der oberen Fläche (2) des Basiselements (1) liegt, die Stange (19) ist mit einem Paar an Rollen (20) ausgestattet, die auf dazugehörigen Lagern symmetrisch angeordnet sind und die voneinander einen Abstand von mehr als der Breite der sandwichartigen Anordnung (3) quer zur Längsrichtung, die sich zwischen den Enden erstreckt, aufweisen, und das Basiselement (1) ist an seiner oberen Fläche (2) mit einem Paar an vertieften Buchten (23) ausgestattet, von denen jede mit der Rille (22) verbunden und so ausgelegt ist, daß zumindest ein Teil einer dazugehörigen Rolle (20) aufgenommen werden kann, wenn die Stange (19) von der Rille (22) aufgenommen wird.

10. Einrichtung gemäß Anspruch 9, wonach das Basiselement (1) an seiner oberen Fläche (2) mit einem Paar an vertieften Spuren (21) ausgestattet ist, von denen jede mit einer dazugehörigen vertieften Bucht (23) versehen ist, die sich in Längsrichtung erstreckt und so ausgelegt ist, daß sie einen Teil einer dazugehörigen Rolle (20) aufnehmen und die Stange (19) parallel zur Querrichtung positionieren kann.

11. Einrichtung gemäß Anspruch 8, wonach das Bewegungsmittel (13-18) aus zwei Leitschienen (14), die am Basiselement (1) parallel zur Längsrichtung angebracht sind, einem Schlitten (13), der auf den Leitschienen (14) gleitet und mit einer Gewindebohrung (16) parallel zur Längsrichtung versehen ist, und einer Spindel (17) besteht, die so ausgelegt ist, daß sie in die Bohrung (16) eingeschraubt werden kann und mit einem Ende gegen das Basiselement (1) stößt und mit dem anderen Ende (18) der Spindel (17) die Spindel rotiert werden kann, wobei das zweite Greifmittel (8) so am Schlitten angebracht ist, daß es durch das Bewegungsmittel (13-18) am Basiselement (1) angeordnet werden kann.

12. Einrichtung gemäß Anspruch 11, wonach es sich beim Greifmittel (7, 8) um Klammern (9) handelt, die so ausgelegt sind, daß sie in eine Druckrichtung rechtwinklig zur oberen Fläche (2) des Basiselements (1) beziehungsweise durch ein Paar an Spindeln (10), die in Druckrichtung in dazugehörige Bohrungen (11) des Basiselements (1) und des Schlittens (13) eingeschraubt sind, gegen das Basiselement (1) und den Schlitten (13) gedrückt werden können, wobei die Spindeln (10) mit dazugehörigen Knöpfen (12) ausgestattet sind, die so ausgelegt sind, daß sie in Druckrichtung gegen eine obere Fläche der dazugehörigen Klammer (9) parallel zur und weg von der oberen Fläche (2) des Basiselements (1) gedrückt werden, wobei die Spindeln (10) voneinander einen Abstand von mehr als der Breite der sandwichartigen Anordnung (3) besitzen.

13. Einrichtung gemäß Anspruch 12, wonach ein Federmittel vorhanden ist, um die Klammern (9) vom Basiselement (1) bzw. vom Schlitten (13) weg und gegen die Knöpfe (12) der dazugehörigen Spindeln (10) zu drücken.

## Revendications

1. Procédé pour casser une pièce à travailler (4) en forme de plaquette, comme une plaquette à gravure, en barres individuelles, comprenant les étapes suivantes consistant à :
- découper une des surfaces de la pièce à travailler selon au moins une ligne de découpe pour définir un plan de séparation de la pièce à travailler;
- placer la pièce à travailler (4), sa surface découpée dirigée vers le haut, entre une feuille supérieure (6) et une feuille inférieure (5), les deux feuilles étant flexibles et extensibles et dépassant des bords de la pièce à travailler, un adhésif servant à réunir la pièce à travailler (4) et la feuille inférieure (5);
- tendre les deux feuilles alors que la pièce à travailler est prise en sandwich entre les deux, la pièce à travailler entravant au moins partiellement l'étirage dans les limites de la portion de la feuille inférieure à laquelle elle adhère;
- appliquer une force ascendante sur le côté inférieur de la structure en sandwich (3) pour ployer la pièce à travailler (4) en sorte que tout rayon de courbure résultant soit perpendiculaire aux lignes de découpe tracées sur le côté convexe de la pièce à travailler, afin que la pièce se casse en barres individuelles selon les lignes de découpe, permettant ainsi à la portion de la feuille inférieure (5) à laquelle la pièce à travailler (4) a été initialement jointe, et à laquelle les barres adhèrent encore, de se tendre encore plus pour séparer les barres individuelles suffisamment afin d'éviter tout endommagement mutuel des surfaces de clivage adjacentes; et
- ôter la feuille supérieure (6) , tout en maintenant la feuille inférieure (5) tendue, pour permettre de détacher les barres individuelles de la feuille inférieure (5) en vue de leur traitement ultérieur.

2. Procédé selon la revendication 1, dans lequel la résistance à la traction de la feuille inférieure (5) est inférieure à la résistance à la traction de la feuille supérieure (6).

3. Procédé selon la revendication 1, dans lequel le sandwich (3) est étiré au-delà de la limite de déformation élastique de la feuille inférieure (5) et de la feuille supérieure (6).

4. Procédé selon la revendication 1, dans lequel la pièce à travailler (4) est à base d'arséniure de gallium, de phosphure d'indium ou de silicium.

5. Procédé selon la revendication 1, dans lequel la pièce à travailler (4) est composée d'un corps amorphe et est en verre.

6. Procédé selon la revendication 1, dans lequel un morceau de feuille intermédiaire (26) est intercalé entre la surface supérieure de la pièce à travailler (4) et la feuille supérieure (6), la feuille intermédiaire étant plus grande que la pièce à travailler qu'elle déborde de tous les côtés.

7. Procédé selon la revendication 6, dans lequel la feuille intermédiaire (26) est à base de polyester ou de polyimide.

8. Dispositif pour casser une pièce à travailler en forme de plaquette (4) prise en sandwich entre deux feuilles flexibles (5, 6), comprenant :
- un élément de base (1) composé d'une surface supérieure plane (2) dont l'étendue en longueur est supérieure à l'étendue transversale;
- un premier dispositif de serrage (7) placé de manière fixe à une extrémité de l'élément de base, conçu et disposé en sorte de pouvoir maintenir et libérer une extrémité du sandwich (3) formé par la plaquette et les feuilles;
- un deuxième dispositif de serrage (8) disposé de manière mobile par rapport à l'élément de base et placé à son autre extrémité en sorte de pouvoir se déplacer dans le sens longtiudinal, conçu et disposé pour pouvoir maintenir et libérer l'autre extrémité du dit sandwich (3);
- un dispositif déplaceur (13-18) disposé pour pouvoir déplacer de façon variable de second dispositif de serrage (8) dans le sens longitudinal; et
- une tige cylindrique (19) adaptée pour pouvoir se placer sur la surface supérieure (2) de l'élément de base (1), son axe étant parallèle au sens transversal, et pour pouvoir se déplacer dans le sens longitudinal.

9. Dispositif selon la revendication 8, dans lequel l'élément de base (1) comprend sur sa surface supérieure (2), une rainure (22) parallèle au sens transversal et adaptée pour recevoir la tige (19) afin qu'elle s'y loge complètement sous le plan de la surface supérieure (2) de l'élément de base (1); la tige (19) est munie d'une paire de rouleaux (20) montés symétriquement sur celle-ci via des roulements, et espacés l'un de l'autre d'une distance supérieure à la largeur du sandwich (3) transversale au sens longitudinal entre ses extrémités; et l'élément de base (1) est muni, sur sa surface supérieure (2), de deux évidements (23) reliés à la rainure (22) et conçus pour pouvoir recevoir chacun au moins une partie d'un rouleau (20) respectif lorsque la tige (19) est logée dans la rainure (22).

10. Dispositif selon la revendication 9, dans lequel l'élément de base (1) est muni, sur sa surface supérieure (2), d'une paire de glissières encastréées (21) reliées chacune à un évidement (23) respectif, s'étendant dans le sens longitudinal et conçues pour recevoir une partie d'un rouleau (20) respectif afin de positionner la tige (19) parallèlement au sens transversal.

11. Dispositf selon la revendication 8, dans lequel le dispositif déplaceur (13-18) comprend, de préférence, deux barres de guidage (14) fixées à l'élément de base (1) parallèlement au sens longitudinal; un chariot (13) glissant sur les barres de guidage (14) et ayant un alésage (16) fileté parallèle au sens longitudinal; et une broche (17) conçue pour pouvoir se visser dans l'alésage (16) et pour que l'une de ses extrémités viennent buter contre l'élément de base (1) tandis que son autre extrémité sert à faire tourner la broche (17), le second dispositif de serrage (8) étant fixé au chariot (13) afin d'être relié à l'élément de base (1) via le dispositif déplaceur (13-18).

12. Dispositif selon la revendication 11, dans lequel le dispositif de serrage (7, 8) est composé de crampons (9) conçus en sorte de subir une pression dans un sens perpendiculaire à la surface supérieure (2) de l'élément de base (1), pression exercée contre, respectivement, l'élément de base (1) et le chariot (13), par le biais d'une paire respective de broches (10) vissées, dans le sens de la pression, dans des alésages (11) respectifs de l'élément de base (1) et du chariot (13), les broches (10) étant munies respectivement de boutons (12) venant buter, dans le sens de la pression, contre la surface supérieure du crampon (9) respectif placé parallèlement à la surface supérieure (2) de l'élément de base (1), les broches (10) étant espacées l'une de l'autre d'une distance supérieure à la largeur du sandwich (3).

13. Dispositif selon la revendication 12, dans lequel on a prévu des dispositifs à ressort pour écarter les crampons (9) de l'élément de base (1) et du chariot (13), respectivement, jusqu'à ce qu'ils viennent buter contre les boutons (12) des broches (10) respectives.
